# DEMANDE DE BREVET EUROPEEN

(11) **EP 0 889 504 A1**
(43) Date de publication de la demande: **07.01.1999**
(21) Numéro de dépôt: 98410075.0
(22) Date de dépôt: 29.06.1998
(51) Int. Cl.: H01L 21/28, H01L 29/49

(54) **Procédé de réalisation de grille de transistors MOS à forte teneur en germanium**

(30) Priorité: 30.06.1997 FR 9708457
(71) Demandeur: SGS-THOMSON MICROELECTRONICS S.A., 94250 Gentilly (FR); FRANCE TELECOM, 75015 Paris (FR)
(72) Inventeur: Dutartre, Didier, 38240 Meylan (FR)
(74) Mandataire: de Beaumont, Michel

(57) **Abrégé**

L'invention concerne un procédé de formation d'une grille de transistor MOS en Si₁₋ₓGeₓ où x est supérieur à 50 %, sur une couche d'isolant de grille en oxyde de silicium, consistant à déposer une couche (11) de Si_{1-y}Ge_{y} d'épaisseur inférieure à 10 nm, où 0<y<30%, et à déposer une couche (12) de Si_{1-z}Ge_{z} d'épaisseur souhaitée, où z > 50 %. L'épaisseur souhaitée est par exemple comprise entre 20 et 200 nm. x et z sont par exemple compris entre 80 et 90 %.

## Description

La présente invention concerne la fabrication de composants semiconducteurs et plus particulièrement de transistors MOS dans un substrat de silicium.

De façon courante, les transistors MOS fabriqués sur un substrat de silicium ont des grilles en silicium polycristallin séparées du substrat par une couche mince d'oxyde de silicium. Il est connu que la tension de seuil des transistors MOS dépend notamment de la nature du matériau constituant la grille conductrice au-dessus de cette couche mince d'oxyde de silicium. En particulier, il est connu que le fait de prévoir comme matériau de grille du germanium ou un mélange Si₁₋ₓGeₓ de silicium et de germanium, avec x > 50 %, fortement dopé de type P, permet d'obtenir des transistors MOS à canal N et à canal P dont les tensions de seuil sont voisines de 0,6 volt.

Toutefois, la réalisation de tels transistors à grille en Si₁₋ₓGeₓ se heurte à divers problèmes pratiques. L'un de ces problèmes est que le germanium et/ou les mélanges de germanium et de silicium à forte teneur en germanium se déposent difficilement sur de l'oxyde de silicium et que l'on obtient des couches rugueuses et irrégulières. En outre, les radicaux de GeHₓ, présents lors du processus de dépôt par voie chimique en phase vapeur (CVD) réalisé en présence de silane et de germane, sont très réactifs et fortement réducteurs et risquent d'attaquer la surface de la couche d'oxyde mince d'isolement de grille, d'où il résulte que cette couche, après dépôt, n'a plus les qualités électriques souhaitées et/ou a une épaisseur irrégulière.

Ainsi, un objet de la présente invention est de prévoir un procédé de formation de grille de transistor MOS en Si₁₋ₓGeₓ qui permette le dépôt d'une grille d'une épaisseur régulière sans affecter la couche d'oxyde sous-jacente.

Bien que la présente description se réfère à titre d'exemple à une grille de transistor MOS, l'homme de l'art comprendra que l'invention s'applique de façon générale au cas où l'on cherche à former une couche de Si₁₋ₓGeₓ avec x supérieur à 50 % sur une couche d'oxyde mince pour former des composants autres qu'un transistor MOS, par exemple des cellules mémoire de divers types.

Pour atteindre cet objet, la présente invention prévoit un procédé de formation d'une grille de transistor MOS en Si₁₋ₓGeₓ où x est supérieur à 50 %, sur une couche d'isolant de grille en oxyde de silicium, comprenant les étapes consistant à déposer une couche de Si_{1-y}Ge_{y} d'épaisseur inférieure à 10 nm, où 0<y<30% ; et à déposer une couche de Si_{1-z}Ge_{z} d'épaisseur souhaitée, où z > 50 %.

Selon un mode de réalisation de la présente invention, l'épaisseur souhaitée est comprise entre 20 et 200 nm.

Selon un mode de réalisation de la présente invention, x et z sont compris entre 80 et 90 %.

Selon un mode de réalisation de la présente invention, le procédé comprend en outre l'étape consistant à déposer une couche d'encapsulation en silicium polycristallin.

Selon un mode de réalisation de la présente invention, le procédé comprend, avant le dépôt de la couche d'encapsulation, l'étape consistant à déposer une couche constituant une barrière de diffusion pour le silicium et le germanium.

Selon un mode de réalisation de la présente invention, la couche barrière est une couche de nitrure de titane, éventuellement déposée sur une couche d'accrochage en titane.

Ces objets, caractéristiques et avantages, ainsi que d'autres de la présente invention seront exposés en détail dans la description suivante de modes de réalisation particuliers faite à titre non-limitatif en relation avec les figures jointes pond lesquelles :
la figure 1 représente une vue en coupe d'une structure que l'on cherche à obtenir ;
la figure 2 illustre schématiquement le procédé selon l'invention ;
la figure 3 représente une première variante du procédé selon l'invention ; et
la figure 4 représente une deuxième variante du procédé selon l'invention.

Conformément à l'usage, dans le domaine de la représentation des composants semiconducteurs, les diverses vues en coupe ne sont pas tracées à l'échelle.

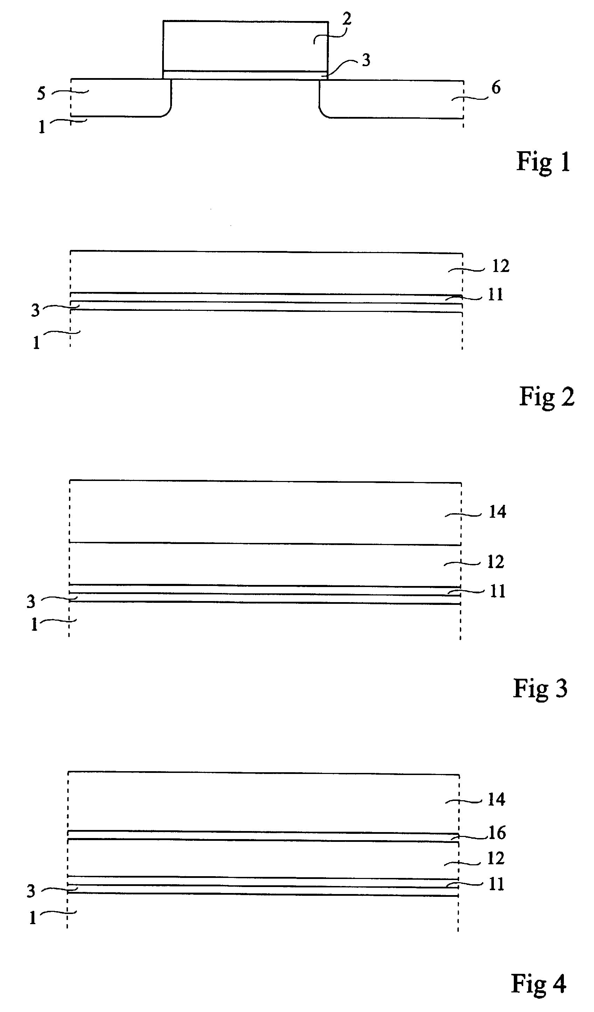

La figure 1 représente très schématiquement l'allure d'un transistor MOS comprenant au-dessus d'un substrat une région de grille conductrice 2 séparée du substrat par une couche isolante mince 3 et comprenant, dans le substrat, de part et d'autre de la grille 2 des régions de source et de drain 5 et 6.

Comme on l'a indiqué précédemment, l'objet de la présente invention est de réaliser une telle structure dans laquelle le substrat est en silicium monocristallin, l'isolant de grille 3 est en oxyde de silicium d'une épaisseur de l'ordre de 2 à 8 nm et dont la grille 2 est en germanium ou en Si₁₋ₓGeₓ avec x supérieur à 50 % et de préférence compris entre 80 et 90 %.

Pour atteindre cet objet et éviter les difficultés de dépôt d'une couche de germanium ou de Si₁₋ₓGeₓ directement sur une couche d'oxyde de silicium, la présente invention prévoit, comme l'illustre la figure 2, de déposer au-dessus de la couche d'oxyde de silicium 3 formée sur le substrat 1, successivement une première couche mince 11 de silicium ou de Si_{1-y}Ge_{y} avec 0 < y < 30 % puis une couche 12 de Si_{1-z}Ge_{z} avec z > 50%, de préférence compris entre 70 et 90%. La couche 11 de Si_{1-y}Ge_{y} a une épaisseur très faible, par exemple comprise entre 1 et 10 nm et la couche 12 a l'épaisseur souhaitée pour la grille, par exemple de l'ordre de 20 à 200 nm.

La couche 11 est déposée par tout procédé classique de dépôt de silicium polycristallin, par exemple par dépôt chimique en phase vapeur (CVD) à une température comprise entre 450 et 650°C et dans des conditions de pression choisies notamment en fonction de la vitesse de croissance désirée. Ce dépôt de silicium polycristallin est généralement effectué à partir de silane dans une atmosphère de silane et d'hydrogène. On pourra éventuellement rajouter à l'atmosphère de dépôt du germane (GeH₄) à une concentration suffisamment faible pour ne pas risquer d'attaque (de réduction) de la couche d'isolant de grille et pour conserver un dépôt régulier.

La couche 12 est également déposée par voie chimique en phase vapeur à partir de silane et de germane, avec une concentration majoritaire en germane. On constate que la couche 12 de Si_{1-z}Ge_{z} se dépose sans problèmes particuliers (ni nucléation, ni rugosité) au-dessus d'une couche de silicium polycristallin, éventuellement à faible teneur de germanium. Ce dépôt est également effectué à une température de l'ordre de 400 à 600°C.

Après réalisation complète du dispositif, on constate que l'ensemble des couches 11 et 12 constitue une couche de composition uniforme de Si₁₋ₓGeₓ ayant la teneur souhaitée, à condition d'avoir convenablement choisi les proportions de silicium et de germanium dans chacune des couches 11 et 12. Ceci résulte d'une diffusion du silicium dans le germanium. Cette diffusion commence à se produire aux températures de dépôt de la couche 12 puis se produit ensuite lors des étapes thermiques ultérieures de fabrication du dispositif, par exemple le recuit thermique de source et de drain qui implique couramment des températures de l'ordre de 1000°C pendant plusieurs secondes, et/ou pendant les étapes de dépôt de couches d'oxyde de silicium déposées entre niveaux de métallisations, ces étapes impliquant couramment des températures de l'ordre de 800°C pendant plusieurs minutes. Bien entendu, l'épaisseur de la couche 11 sera choisie suffisamment faible pour que la diffusion du silicium dans le germanium résulte en une dissolution de la couche 11 dans la couche 12. Cette épaisseur sera de préférence comme on l'a indiqué précédemment de l'ordre de 1 à 10 nm.

Lors d'étapes ultérieures de fabrication, on souhaite généralement établir un contact avec la grille et/ou procéder à une métallisation de celle-ci. Etant donné que les procédés bien connus dans le domaine de la fabrication des semiconducteurs font appel à des grilles en silicium polycristallin et à des reprises de contact sur les grilles de silicium polycristallin, on souhaitera de façon générale éviter d'avoir à développer un procédé spécifique pour établir des contacts sur du germanium ou du Si₁₋ₓGeₓ avec x supérieur à 50 %.

En conséquence, comme le représente la figure 3, on procédera de préférence, après l'étape illustrée en figure 2 au dépôt d'une couche supplémentaire de silicium polycristallin 14, comme cela est représenté en figure 3. La couche 14 constitue en outre une couche d'encapsulation qui protège la couche 12 d'attaques par des oxydes ou des acides. Etant donné l'épaisseur de la couche 12, même si au cours d'étapes thermiques ultérieures, il se produit une certaine diffusion mutuelle du silicium de la couche 14 et du germanium de la couche 12 l'un vers l'autre, une large portion de la couche 12, au voisinage de la couche d'oxyde de grille, demeurera une région de Si₁₋ₓGeₓ où x a une valeur souhaitée pour fixer la tension de seuil d'un transistor MOS. Au cours d'étapes ultérieures, non-représentées, on procédera à la gravure de l'ensemble de la couche de conducteur de grille pour former des grilles de forme et de dimension souhaitées.

Selon une variante de la présente invention, illustrée en figure 4, avant de déposer la couche 14, on forme une couche intermédiaire de barrière de diffusion pour éviter tout amoindrissement du dopage en germanium de la région 11, 12. Cette couche de barrière de diffusion sera par exemple du nitrure de titane, ou du nitrure de titane déposé sur une couche d'accrochage en titane. D'autres barrières de diffusion connues pourront être utilisées.

Enfin, diverses variantes et diverses applications de la présente invention pourront être envisagées par l'homme de l'art, l'aspect essentiel de la présente invention résidant dans l'utilisation d'un dépôt d'une épaisseur non-négligeable, de 1 à 10 nm, riche en silicium, avant le dépôt d'une couche de conducteur de grille riche en germanium.

## Revendications

1. Procédé de formation d'une grille de transistor MOS en Si₁₋ₓGeₓ où x est supérieur à 50 %, sur une couche d'isolant de grille en oxyde de silicium, caractérisé en ce qu'il comprend les étapes suivantes :
déposer une couche (11) de Si_{1-y}Ge_{y} d'épaisseur inférieure à 10 nm, où 0<y<30% ; et
déposer une couche (12) de Si_{1-z}Ge_{z} d'épaisseur souhaitée, où z > 50 %.

2. Procédé selon la revendication 1, caractérisé en ce que ladite épaisseur souhaitée est comprise entre 20 et 200 nm.

3. Procédé selon la revendication 1, caractérisé en ce que x et z sont compris entre 80 et 90 %.

4. Procédé selon la revendication 1, caractérisé en ce qu'il comprend en outre l'étape consistant à déposer une couche d'encapsulation (14) en silicium polycristallin.

5. Procédé selon la revendication 4, caractérisé en ce que, avant le dépôt de la couche d'encapsulation, il comprend l'étape consistant à déposer une couche (16) constituant une barrière de diffusion pour le silicium et le germanium.

6. Procédé selon la revendication 5, caractérisé en ce que ladite couche barrière est une couche de nitrure de titane, éventuellement déposée sur une couche d'accrochage en titane.
